# EUROPEAN PATENT SPECIFICATION

(11) **EP 3 804 055 B1**
(45) Date of publication and mention of the grant of the patent: **03.07.2024**
(21) Application number: 19731508.8
(22) Date of filing: 30.05.2019
(51) Int. Cl.: H01S 5/32, H01S 5/20

(54) **LARGE OPTICAL CAVITY (LOC) LASER DIODE HAVING QUANTUM WELL OFFSET AND EFFICIENT SINGLE MODE LASER EMISSION ALONG FAST AXIS**
LASERDIODE MIT GROSSEM OPTISCHEM RESONATOR (LOC) MIT QUANTENMULDENVERSATZ UND EFFIZIENTER EINMODEN-LASEREMISSION ENTLANG EINER SCHNELLEN ACHSE
DIODE LASER À GRANDE CAVITÉ OPTIQUE (LOC) À DÉCALAGE DE PUITS QUANTIQUES ET ÉMISSION LASER MONOMODE EFFICACE LE LONG D'UN AXE RAPIDE

(30) Priority: 30.05.2018 US 201862677748 P
(43) Date of publication of application: 14.04.2021
(73) Proprietor: NLIGHT, Inc., Vancouver WA 98665 (US)
(72) Inventor: CHEN, Zhigang, Vancouver, Washington 98665 (US); KANSKAR, Manoj, Vancouver, Washington 98665 (US)
(74) Representative: Murgitroyd & Company
(86) International application number: PCT/US2019/034731
(87) International publication number: WO 2019/232261

(56) References cited:
- EP-A1- 3 070 794
- US-A1- 2007 002 914
- US-A1- 2010 150 196
- US-A1- 2012 093 187
- US-A1- 2013 039 376
- GOETZ ERBERT ET AL: "High-Power Highly Reliable Al-Free 940-nm Diode Lasers", IEEE JOURNAL OF SELECTED TOPICS IN QUANTUM ELECTRONICS, IEEE, USA, vol. 7, no. 2, 1 March 2001 (2001-03-01), XP011061912, ISSN: 1077-260X

## Description

### RELATED APPLICATION

### TECHNICAL FIELD

The disclosure pertains to laser diodes.

### BACKGROUND INFORMATION

Some laser diodes, such as those included in high power 8xx- and 9xx-nm commercial laser diode assemblies available from the applicant, nLIGHT, Inc., include a large optical cavity (LOC) for high power and high efficiency performance.

Reference is made to the following documents :
US 2013/039376 A1 (EICHLER )
US 2007/002914 A1 (RYU HAN-YOUL)
US 2010/150196 A1 (ROSSIN).

LOC laser diodes with single mode emission are known from :
US 2012/093187 A1 (KOETH) 19 April 2012;
Erbert GOETZ et AI: "High-Power Highly Reliable Al-Free 940-nm Diode Lasers", IEEE J. of Selected Topics in Quantum Electronics, vol. 7, no. 2, 1 March 2001.

### SUMMARY OF THE DISCLOSURE

The invention is described in the independent claims. Preferred embodiments are given in the dependent claims.

Several embodiments of LOC laser diode structures are described. The embodiments possess relatively thin p-waveguide thickness and yet provide single mode lasing operation in the vertical direction at high power and high efficiency. High power laser diodes are desirable for power scaling and reducing price (measured in cost per Watt). High efficiency laser diodes are desirable for reducing energy consumption and extending device lifetime.

In some examples, a laser diode is configured to suppress lasing of a first and higher order modes along a fast axis of an optical beam emitted by the laser diode. The laser diode has an optical cavity defined by a p-side of the laser diode, an n-side of the laser diode, and an active region located between the p- and n-sides, the n-side including an n-waveguide layer forming at least a portion of a waveguide having a quantum well offset towards the p-side; and adjacent cladding layers on one or both of the p- and n-sides, the adjacent cladding layers including outer and inner cladding layers, the inner cladding layer situated between and adjacent to the waveguide and the outer cladding layer, the outer and inner cladding layers having, respectively, first and second indices of refraction, the first index of refraction of the outer cladding layer being greater than the second index of refraction of the inner cladding layer and greater than an effective index of refraction of the first order mode so as to out-couple it from the waveguide. A graded- or stepped- index refractive index profile may be adjacent to the active region, in some examples.

In other examples, a laser diode is configured to suppress lasing of a first and higher order modes along a fast axis of an optical beam emitted by the laser diode. The laser diode has an optical cavity defined by a p-side of the laser diode, an n-side of the laser diode, and an active region located between the p- and n-sides; and a set of n-waveguide layers on the n-side that form at least a portion of a double waveguide, the set of n-waveguide layers including outer and inner n waveguide layers so as to reduce optical gain applied to the first and higher order modes. The waveguide is symmetric in some examples and asymmetric (with respect to refractive indices) in other examples.

Additional aspects and advantages will be apparent from the following detailed description of embodiments, which proceeds with reference to the accompanying drawings.

### BRIEF DESCRIPTION OF THE DRAWINGS

FIG. 1 is a block diagram of a conventional laser diode, according to the prior art.
FIG. 2 is an annotated block diagram of an epitaxial layer stack including cladding (also called clad), waveguide, and active layers arranged along a vertical axis according to a first single mode laser diode design paradigm (specifically, a design 1a) having a thin p-waveguide thickness (i.e., large quantum well offset) and a double n-clad structure.
FIG. 3 is a graph of a refractive index profile (RIP) for design 1a, showing models of optical intensity profiles of, respectively, fundamental and first order modes having effective indices of refraction indicated by dashed lines for comparison to indices of refraction of inner and outer n-cladding layers of the double clad paradigm introduced in FIG. 2.
FIG. 4 is a graph of a RIP for a single n-clad design variant having a small refractive index step difference (Δn) and showing models of optical intensity profiles of fundamental modes for both the variant and design 1a.
FIG. 5 is a graph of a RIP for a single n-clad design variant having a large Δn and showing models of optical intensity profiles of fundamental and first order modes, which are both confined in a waveguide and therefore result in stimulated emission of multiple optical modes.
FIG. 6 is an annotated graph of a RIP for a single mode laser diode design 1b having an extremely large (i.e., essentially zero p-waveguide thickness) quantum well offset.
FIG. 7 is an annotated graph of a RIP of a single mode laser diode design having a double p-clad structure and a thin p-waveguide thickness (i.e., large quantum well offset).
FIG. 8 is an annotated graph of two RIPs for a second design paradigm including two corresponding large quantum well offset designs 2a and 2b having, respectively, stepped and graded index RIP layers.
FIG. 9 is an annotated graph showing in log scale, for designs 2a and 2b of FIG. 8, models of vertical far field intensity profiles exhibiting relatively little optical power present in high-angle side lobes.
FIG. 10 is an annotated graph of two RIPs for the second design paradigm including two corresponding extremely large quantum well offset designs 2c and 2d having, respectively, stepped and asymmetric graded index RIP layers.
FIG. 11 is an annotated graph showing in log scale, for designs 2c and 2d of FIG. 10, models of vertical far field intensity profiles exhibiting relatively little optical power present in high-angle side lobes.
FIG. 12 is an annotated graph of a RIP of a third large quantum well offset design paradigm in which an outer n-waveguide has a lower index of refraction compared to that of an inner n-waveguide, and in which an optical confinement factor of a fundamental mode is enhanced to 0.5% whereas that of the first order mode is reduced to 0.3%.
FIG. 13 is an annotated graph of a RIP of a fourth large quantum well offset design paradigm in which a thin cladding layer separates a double waveguide structure, and in which an optical confinement factor of a fundamental mode is enhanced to 0.4% whereas that of the first order mode is reduced to 0.2%.
FIG. 14A is a block diagram of a laser diode assembly including laser diodes constructed according to one or more of the disclosed design paradigms.
FIG. 14B is a side elevation view of a stair-step laser diode mount along the line B-B of FIG. 14A.
FIG. 15 is a graph of simulated laser diode voltages (V) as a function of drive current (amps, A) for a conventional LOC design and several thin p-waveguide designs having incrementally thinner p-waveguides along the lines shown in FIGS. 3 and 6 for designs 1a and 1b.
FIGS. 16 and 17 are graphs of simulated electron and hole concentrations and conduction band edge under high power operation for, respectively, a conventional LOC laser diode design and design 1a.
FIG. 18 is a graph of measured voltage as a function of current indicating that, for several thin p-waveguide designs having incrementally thinner p-waveguides along the lines shown in FIGS. 3 and 6 for designs 1a and 1b, power consumption is smaller as p-waveguide thickness is reduced.
FIG. 19 is a graph of measured fast axis far field of the thinnest p-waveguide design of FIG. 18, showing single mode output along the fast axis for measured currents between 10 A and 25 A.
FIG. 20 is a graph of measured voltage and output power as a function of current for a conventional laser diode design and an improved design employing a stepped index RIP layer along the lines shown in design 2a.
FIG. 21 is a graph of measured efficiency as a function of current for a conventional laser diode design and the improved design of FIG. 20.
FIG. 22 is a graph of measured fast axis far field as a function of angle for the improved design of FIG. 20.
FIG. 23 is an annotated graph of a RIP showing a combination of a double waveguide and a double cladding, according to another embodiment.

### DETAILED DESCRIPTION OF EMBODIMENTS

Laser diodes can be made for operation over a wide range of wavelengths depending on selected materials. For example, such laser diodes can be made of InGaN, AlGaInP, GaAlAs, InGaAs, GaAsP, InGaAsP, InGaAsNSb, or GaInAsSb for lasing wavelengths that range from at least about 400 nm (InGaN) to about 3.4 µm (GaInAsSb). Lasing wavelength refers to actual emission wavelength of a laser diode. Actual emission wavelength varies with temperature, drive current, laser cavity length; as used herein, lasing wavelength also refers to a spectral bandwidth at which a laser diode can emit, which is typically quantified in terms of full width half max or full width 1/e² intensity.

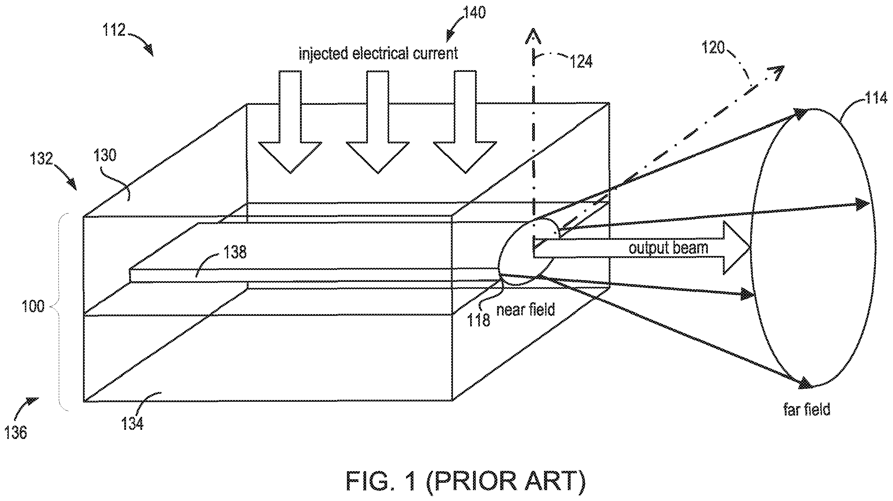

FIG. 1, for example, shows a vertical waveguide 100 of a conventional laser diode 112 emitting laser radiation 114 from a front facet 118 that is longer in one direction than it is in an orthogonal direction such that emitted laser radiation 114 has a smaller divergence in a direction parallel to the longer facet dimension and a larger divergence in a direction parallel to the smaller facet dimension. An axis parallel to and along the longer facet dimension is referred to as a slow axis 120; and an axis parallel to and along a smaller facet dimension is referred to as a fast axis 124. Also, as shown in FIG. 1, vertical waveguide 100 includes a p-waveguide 130 of a p-side 132 of a p-n junction, an n-waveguide 134 on an n-side 136 of the p-n junction, and an active layer 138 (also called active region, and the word layer is sometimes omitted in describing portions of the stack) having one or more quantum well layers and other portions to produce optical gain. N- and p-waveguide layers, as well as in-between layers, are collectively referred to as a waveguide (i.e., vertical waveguide 100 in FIG. 1).

The active region of the laser diode is in the intrinsic region, and the carriers (electrons and holes) are pumped into that region from the n and p regions, respectively (i.e., the n- and p-doped material on opposing sides of a p-n junction). The term active region is also used to generally refer to portions of laser diodes that produce optical gain. In quantum well lasers, the quantum well layers serve as active regions. Thus, in the following examples, so-called quantum well laser diodes include quantum well based active regions.

In conventional laser diode 112, p-waveguide 130 constitutes a significant portion of the overall thickness of vertical waveguide 100. In other words, the quantum well, which sits between p-side 132 and n-side 136, is located more or less in the middle of vertical waveguide 100. But as indicated by P. Crump et al. in "Efficient High-Power Laser Diodes," IEEE Journal of Selected Topics in Quantum Electronics, vol. 19, no. 4, p. 1501211, July-Aug. 2013, a majority of voltage and optical loss occurring at high current 140 is attributable to the thickness of p-waveguide 130.

Some laser diode designs attempt to reduce the thickness, which perforce offsets the quantum well toward a thinner p-side of the vertical waveguide. The large quantum well offset reduces electrical series resistance attributable to the p-waveguide, reduces optical loss and leakage currents associated with carrier accumulation in the p-waveguide under large forward bias, and therefore leads to improved power and efficiency. A large quantum well offset to the p-side of the waveguide in an LOC structure, however, results in the onset of higher order modes in the vertical direction. This is especially true as to the onset of the first order mode, which deteriorates the beam quality in the vertical direction and reduces the power and efficiency of the diodes.

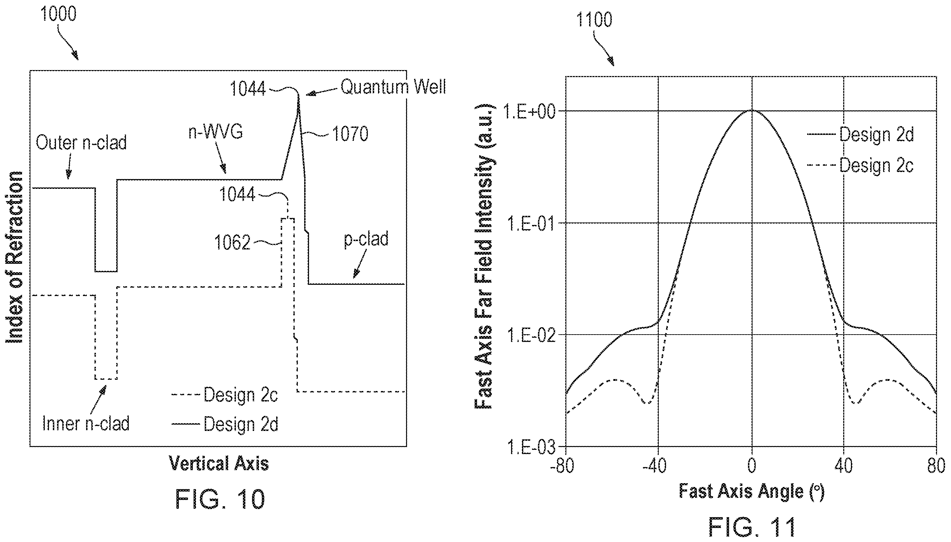

P. Crump et al. describes such designs having reduced p-waveguide thickness and features attempting to produce single mode emission in the vertical direction. Specifically, the design shown in FIG. 10(b) of P. Crump et al., for example, has a reduced p-waveguide thickness and a reduced refractive index step difference between the waveguide and n-cladding (Δn = 0.02) so as to preferentially out-couple a first (higher) order optical mode. This results in single mode emission in the vertical direction but causes certain deficiencies appreciated by the present inventors. For example, a fundamental mode extends significantly into the cladding, leading to large, ill-defined near field, degraded beam quality, and higher intrinsic loss from overlapping with the cladding. Also, the small energy barrier provided by the n-clad as a result of the relatively small Δn (i.e., n-clad index of refraction is just slightly lower than that of the waveguide) may not be sufficient to block carrier/hole leakage into the cladding-which would reduce the intrinsic efficiency of the laser diodes due to carrier leakage. In other words, there is a Δn value below which the waveguide supports one confined mode (i.e., small Δn for single mode lasing of the fundamental mode) and above which the waveguide starts to confine the first order mode (i.e., large Δn causing multimode lasing including the first order mode).

### Design Paradigm 1: Double Clad Structure

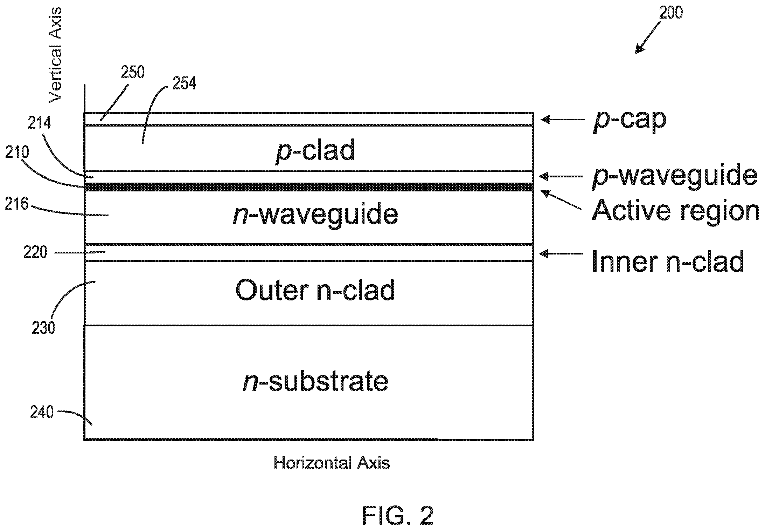

FIG. 2 shows a laser diode 200 representing a design 1a that features a double (i.e., inner and outer) n-clad structure. Laser diode 200 includes an active region 210 situated between a p-waveguide 214 and an n-waveguide 216. N-waveguide 216 is between active region 210 and an inner n-clad 220. Another, outer n-clad 230 is between inner n-clad 220 and an n-substrate 240 at the bottom of the epitaxial layer stack. And a p-cap 250 is atop a p-clad 254 between p-cap 250 and p-waveguide 214. Note that although this and other examples are described with reference to directions indicated as "above," "below," "upper," "lower," "vertical," "horizontal," and the like, these terms are used for ease of description and do not imply any particular spatial orientation or limitation. Also, in the graphs, horizontal arrows clarify which vertical axis corresponds to which plot.

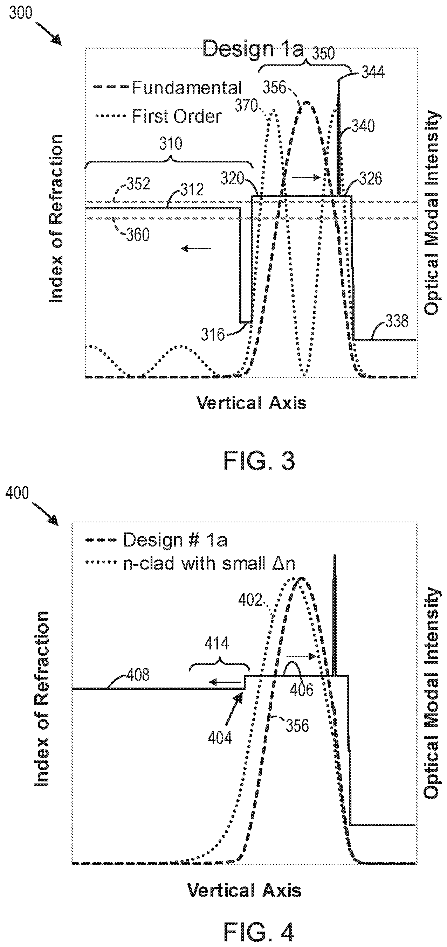

FIG. 3 shows a graph 300 for design 1a including a double n-clad structure 310 having an outer n-clad 312 and a relatively thin inner n-clad 316. Between n- and p-waveguides 320, 326 (the latter of which is adjacent a p-clad 338) is an active region 340 including a quantum well 344. Collectively, n- and p-waveguides 320, 326 and active region 340 form a waveguide 350. The overall thickness of waveguide 350 remains large (as in conventional LOC designs) for a reasonably small far field divergence angle. Multiple optical modes in the vertical direction could be supported under such large optical cavity.

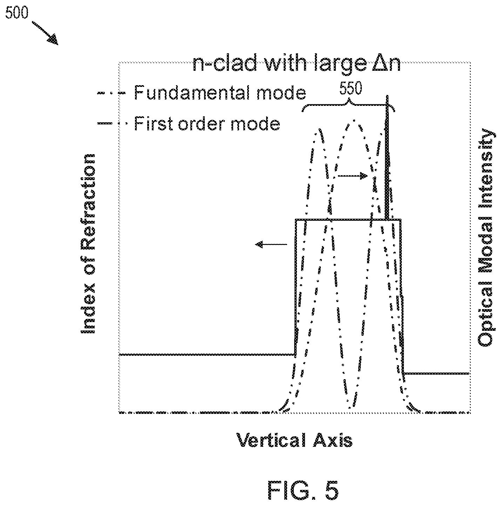

Due to the relatively thin p-waveguide 326, quantum well 344 is significantly offset to the p-side of waveguide 350, which establishes a large quantum well offset that improves power and efficiency. Nevertheless, without outer n-clad 312 acting to suppress undesirable modes for reasons explained below, a large quantum well offset would lead to a confinement factor (Γ, measured as an overlap of an optical mode with a quantum well) of a first order mode being greater than or equal to that of a fundamental mode-lasing of both modes would then deteriorate laser diode performance. But as shown in FIG. 3, an index of refraction of outer n-clad 312 is chosen so that it is both lower than an effective refractive index 352 of a fundamental mode 356 and yet higher than an effective refractive index 360 of a first order mode 370. Outer n-clad 312 also has an index of refraction that is slightly lower than that of waveguide 350. And inner n-clad 316, advantages of which are discussed later with reference to FIGS. 4 and 5, has an index of refraction that is substantially lower than that of waveguide 350 and outer n-clad 312. Such arrangements ensure that fundamental mode 356 is a guided mode by waveguide 350 whereas undesirable modes 370 are anti-guided (i.e., leaky modes) having high optical loss. While fundamental mode 356 is well confined by waveguide 350, first (and higher) order mode 370 is out-coupled to the cladding with high loss, so that laser diodes of design 1a will lase with a single mode in the vertical direction.

Effective refractive indices 352 and 360 help demonstrate how a double n-clad structure confines a fundamental mode and rejects a first (and higher) order modes. In the context of waveguide optics, the term effective refractive index is generally understood to mean the index that is related to the propagation of a waveguide mode. The effective refractive index depends not only on the wavelength but also (for multimode waveguides) on the mode in which the light propagates. For this reason, it is also called modal index. The effective refractive index can be obtained with numerical mode calculations, for example.

FIG. 4 is a graph 400 comparing fundamental mode 356 of design 1a with a fundamental mode 402 of another design in which there is a relatively small Δn 404 between an n-waveguide 406 and a single n-clad 408. As described previously, because the so-called small Δn design of FIG. 4 lacks inner n-clad 316 (FIG. 3), its fundamental mode 402 extends significantly 414 into single n-clad 408 (compared to fundamental mode 356) leading to large near field, diminished beam quality, and higher intrinsic loss from overlapping with n-clad 408. On the other hand, as shown in a graph 500 of FIG. 5, a large Δn design would result in the lasing of higher order modes confined to a waveguide 550. Thus, to overcome deficiencies of the small and large Δn designs, design 1a has a high bandgap energy barrier provided by inner n-clad 316 that suppresses carrier (hole) leakage into n-clad 310, ensuring high intrinsic efficiency of double n-clad laser diode designs while rejecting the higher order modes.

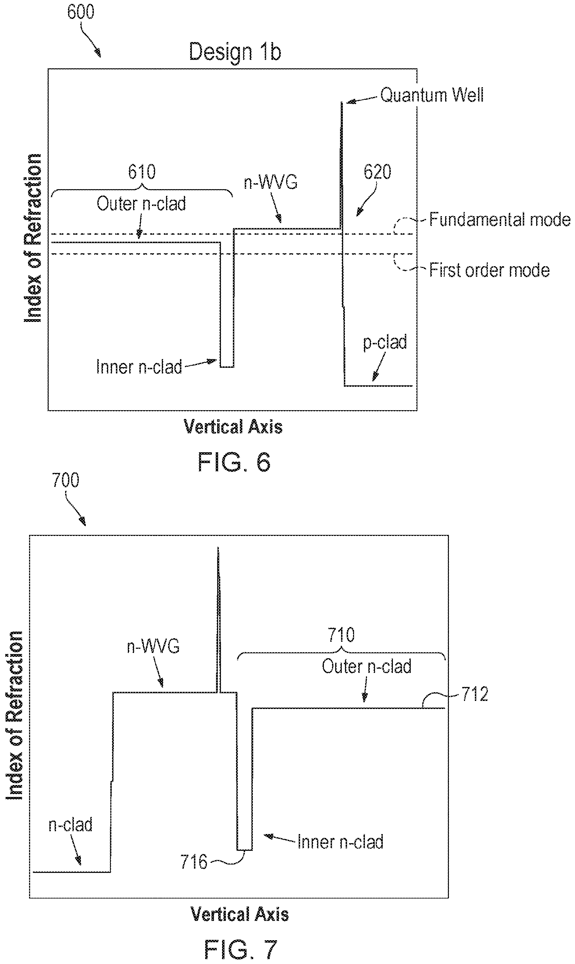

FIG. 6 is a graph 600 showing design 1b having an extreme quantum offset. As in design 1a, a double n-clad structure 610 is employed. In contrast to design 1a, design 1b has an extremely thin or no p-waveguide 620. For similar reasons as those discussed previously, laser diodes of design 1b will also lase with a single mode. Both double n-clad designs 1a and 1b (referred to generally as design 1) provide sufficient confinement to the fundamental mode for less modal extension into the cladding and well-defined modal near field, while suppressing higher order modes by introducing sufficient loss.

The following tables provide example thicknesses and refractive indices of designs 1a and 1b.

| Table 1: Example Thicknesses and Refractive Indices for Design 1a | | |
|---|---|---|
| layer description | thickness (λ₀) | index of refraction |
| p-cap | | |
| p-clad | | 3.2 |
| p-waveguide | 0.2 | 3.4 |
| active region | | |
| n-waveguide | 1.6 | 3.4 |
| | | |
| inner n-clad | 0.2 | 3.2 |
| outer n-clad | | 3.38 |
| n-substrate | | |

| Table 2: Example Thicknesses and Refractive Indices for Design 1b | | |
|---|---|---|
| layer description | thickness (λ₀) | index of refraction |
| p-cap | | |
| p-clad | | 3.2 |
| p-waveguide | 0.0 | 3.4 |
| active region | | |
| n-waveguide | 1.8 | 3.4 |
| | | |
| inner n-clad | 0.2 | 3.2 |
| outer n-clad | | 3.38 |
| n-substrate | | |

Skilled persons will appreciate that actual layer thicknesses are generally independently selected to provide desired optical coupling. Some or all layer thicknesses can be adjusted as desired. In general, inner n-clad 316, including the choice of its index of refraction and layer thickness, is chosen to have much lower index of refraction than that of the waveguide, and usually has much higher bandgap energy than the waveguide as well.

FIG. 7 is a graph 700 showing another double clad design on the p-side instead of on the n-side. A double p-clad structure 710 would entail greater electron leakage into, and appreciable modal loss from, a p-clad, but this design nevertheless achieves similar modal discrimination to suppress higher order modes due to the position and indices of refraction of an outer p-clad 712 and an inner p-clad 716, which are functionally akin to outer and inner n-clad 312, 316.

### Design Paradigm 2: Active Regions Having High-Index RIPs

In design paradigm 1, because of the large quantum well offset, the confinement factor is reduced compared to conventional LOC laser diodes. For example, the confinement factor of design 1a and design 1b is 0.26% and < 0.1%, respectively, compared to 0.5-0.6% in a conventional LOC design. This results in lower modal gain and increased threshold current, and could potentially limit power and efficiency of the laser diodes in some applications.

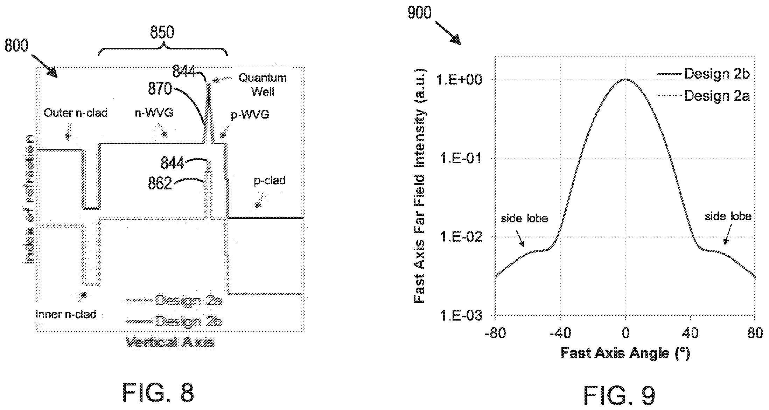

A design paradigm 2 (including variants 2a, 2b, 2c, and 2d) has a similar double n-clad structure as that of design 1, but has a high-index RIP adjacent to the active regions that enhance optical confinement at the quantum well and, therefore, provide higher modal gain and reduced threshold current. Note that in FIG. 8, design 2a is shown as having an overall lower index of refraction compared to that of design 2b, but this difference is simply so one design does not occlude the other-the actual indices of refraction could be similar. Likewise, FIG. 10 shows a similar overall difference between designs 2c and 2d, which is also provided for clarity.

FIG. 8 is a graph 800 showing designs 2a and 2b. In both designs, a high index RIP surrounds quantum well 844 to help increase modal overlap with the quantum well and has higher index of refraction than that of waveguide 850. In other words, high index RIP functions as a higher index layer to help enhance the confinement factor.

In design 2a, the high index RIP is a stepped index layer 862. In design 2b, a graded index RIP 870 is used. Both designs have a confinement factor of 0.52%, which is about double that of design 1a. Other possible designs include: a design similar to design 2a, but with asymmetric high index stepped index RIP surrounding active region, i.e. the stepped index layer on the p-side is thinner than that on the n-side or is of no thickness; and a design similar to design 2b, but with the p-side of the graded index RIP having a more rapid index of refraction gradient or is of no thickness.

A graph 900 of FIG. 9 shows that the RIPs of designs 2a and 2b result in high-angle side lobes in the vertical far field, but the side lobes contain just a small portion of the overall power. For example, about 1% of the power is enclosed in the side lobes for both designs. In other words, assuming that the power at high far field angles is lost, the side lobes amount to about a 1% power loss over design 1a.

A graph 1000 of FIG. 10 shows the RIPs of designs 2c and 2d, each with extreme quantum well offset. Because the confinement factor in designs with extreme quantum well offset is low, such as that of design 1b (< 0.1 %), an index profile around quantum well 1044 is modified in FIG. 10.

Design 2c includes a high index stepped index RIP layer 1062 on either side of quantum well 1044, which is similar to design 2a described previously. Design 2c has a 0.26% confinement factor, which is the same as that of design 1a, even though the p-waveguide is removed completely. Design 2c can also have asymmetric stepped index RIP surrounding active region, i.e. the stepped index layer on the p-side is thinner than that on the n-side or it is of no thickness.

Design 2d includes an asymmetric graded index RIP layer 1070, with the p-side of the layer having a more rapid index of refraction gradient or it is of no thickness. The purpose of the asymmetric RIP layer is to enhance the confinement factor while minimizing p-waveguide thickness. Specifically, in design 2d, a confinement factor of 0.38% is achieved in extreme quantum well offset design, which is greatly improved over design 2c. In other designs, however, a symmetric graded index RIP layer (not shown) or other types of RIP layers may be used to enhance the confinement factor.

A graph 1100 of FIG. 11 plots modeled vertical far field intensity profiles for designs 2c and 2d. Both designs have small power loss in the high angle side lobes, with design 2c having less than 1% and design 2d having less than 2% power loss.

In terms of example thicknesses and indices of refraction for variants of this design paradigm 2, such thicknesses and indices of refraction would be similar to those of Tables 1 and 2 except for the thin high index RIP surrounding the quantum well.

### Design Paradigm 3:

### Double Waveguide Structure Having Asymmetric Refractive Index

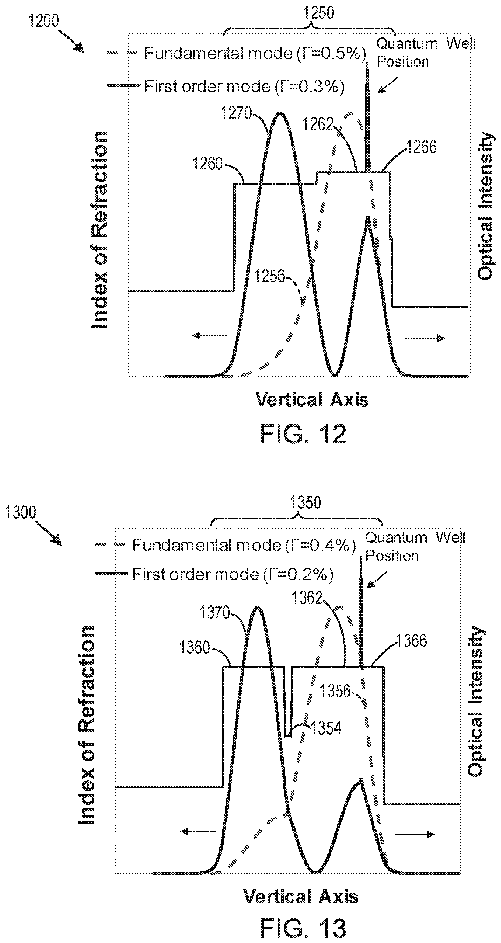

FIG. 12 is a graph 1200 showing a RIP for design paradigm 3. The design includes a double waveguide 1250 including an outer n-waveguide layer 1260, an inner n-waveguide layer 1262, and large quantum well offset to a thin p-waveguide 1266 on the p-side of waveguide 1250.

Outer n-waveguide 1260 has a slightly lower index of refraction than that of inner n-waveguide 1262 and thin p-waveguide 1266. Thus, double waveguide 1250 is asymmetric with respect to refractive indices because they differ on opposite sides of waveguide 1250. As explained in the following paragraph, there is significant power of a fundamental mode present in outer n-waveguide 1260. For this reason, outer n-waveguide layer 1260 is not referred to as an inner n-cladding layer. Nevertheless, irrespective of whether it is called inner n-clad or outer n-waveguide is largely irrelevant to the operating principle: both fundamental and higher (i.e., first) order modes are confined modes in design paradigm 3, as opposed to the design paradigms 1 and 2. The first order mode is suppressed in design paradigm 3 not because it is out-coupled, but because its modal gain is lower than that of the fundamental mode.

Under double waveguide 1250, a fundamental mode 1256 tends to overlap more with the higher index region of inner n-waveguide 1262, while a first order mode 1270 overlaps more with the lower index region of outer n-waveguide 1260. Fundamental mode 1256 for the specific structure has an enhanced confinement factor of 0.5%, compared to 0.2% under a symmetric waveguide of the same thickness and quantum well offset. First order mode 1270 has a confinement factor of 0.3%, reduced significantly from 0.4% in the symmetric waveguide. An enhanced modal discrimination of fundamental mode 1256 results from the increased modal gain of it relative to first order mode 1270, allowing the laser diode to run in single mode in the vertical direction. For comparison, design paradigm 1 and 2 achieve enhanced modal discrimination of fundamental modes through increased loss of the first order modes.

The following table provide example thicknesses and refractive indices of design 3.

| Table 3: Example Thicknesses and Refractive Indices for Design 3 | | |
|---|---|---|
| layer description | thickness (λ₀) | index of refraction |
| p-cap | | |
| p-clad | | 3.2 |
| p-waveguide | 0.2 | 3.4 |
| active region | | |
| inner n-waveguide | 0.6 | 3.4 |
| | | |
| outer n-waveguide | 1.0 | 3.38 |
| n-clad | | 3.2 |
| n-substrate | | |

### Design Paradigm 4:

### Double Waveguide Structure Having Symmetric Refractive Index

FIG. 13 is a graph 1300 showing a RIP for design paradigm 4. The design includes a double waveguide 1350 formed from two waveguides separated by a thin cladding layer 1354 offset more towards thinner waveguide 1360 than thicker waveguide 1362. Thicker waveguide 1362 includes both an n-waveguide to the right of thin cladding layer 1354 and a p-waveguide 1366. Thin cladding layer 1354 has a lower index of refraction (also typically higher bandgap energy) compared to that of double waveguides 1350. A quantum well sits offset to the p-side of double waveguide 1350 with very thin p-waveguide 1366 thickness.

Under the double waveguide having unequal thicknesses among the two waveguides, a first order mode 1370 overlaps more with thinner waveguide 1360 to the n-side of thin cladding layer 1354 whereas a fundamental mode 1356 tends to overlap more with thicker waveguide 1362 to the p-side of the cladding layer. For the specific structure of FIG. 13, fundamental mode 1356 has an enhanced confinement factor of 0.4% and first order mode 1370 has a confinement factor of 0.2%, resulting in an improved modal discrimination between the modes, and single mode operation in the vertical direction.

To characterize the aforementioned improvement according to one example, note that in laser structures with less than 0.9 cm⁻¹ intrinsic modal loss, a modal discrimination factor that produces greater than two times (or higher) threshold (explained below) is considered to be a good modal discrimination for single mode operation. At this threshold, higher order modes are considered to be suppressed, as a practical matter. Skilled persons will appreciate, however, that other thresholds may be suitable for different applications so as to increase the threshold current of higher order modes to a desired amount that is higher than the threshold current of a fundamental mode. In practice, the threshold current is related to the confinement factor (modal gain) as well as the intrinsic modal loss (different modes have different losses), so threshold current does not depend on confinement factor alone. Higher order modes having a threshold current of greater than about two or three times that of the threshold current of the fundamental mode may not lase at all, which is to say that such ranges are implementation specific and need not have a direct correspondence to the confinement factor.

The thickness and refractive index of cladding layer 1354 is judiciously chosen to achieve the maximum modal discrimination between the fundamental and first order mode-too thin a layer will reduce the modal discrimination, but too thick a layer will result in modes confined in individual waveguides, departing from the LOC design principle. In other words, if cladding layer 1354 is too thick, then that would result in two uncoupled waveguides in which light is confined to the one waveguide having the quantum well rendering the double waveguide design paradigm inoperable.

The following table provide example thicknesses and refractive indices of design 4.

| Table 4: Example Thicknesses and Refractive Indices for Design 4 | | |
|---|---|---|
| layer description | thickness (λ₀) | index of refraction |
| p-cap | | |
| p-clad | | 3.2 |
| p-waveguide | 0.2 | 3.4 |
| active region | | |
| inner n-waveguide | 1.0 | 3.4 |
| thin clad | 0.1 | 3.3 |
| outer n-waveguide | 0.6 | 3.38 |
| n-clad | | 3.2 |
| n-substrate | | |

### Laser Diode Assembly

The previously described design paradigms have applicability in, among other things, fiber-coupled pump products such as element^{®} and pearl^{™} laser diodes available from the applicant, nLIGHT, Inc. of Vancouver, Washington. For example, the ability to scale power by increasing the output power per single emitter diode at high efficiency and without modifying pump designs or piece-part counts significantly reduces the pump cost (cost per Watt). Also, the improved efficiency helps reduce energy consumption and extend the lifetime of the laser diode and laser diode products incorporating such devices.

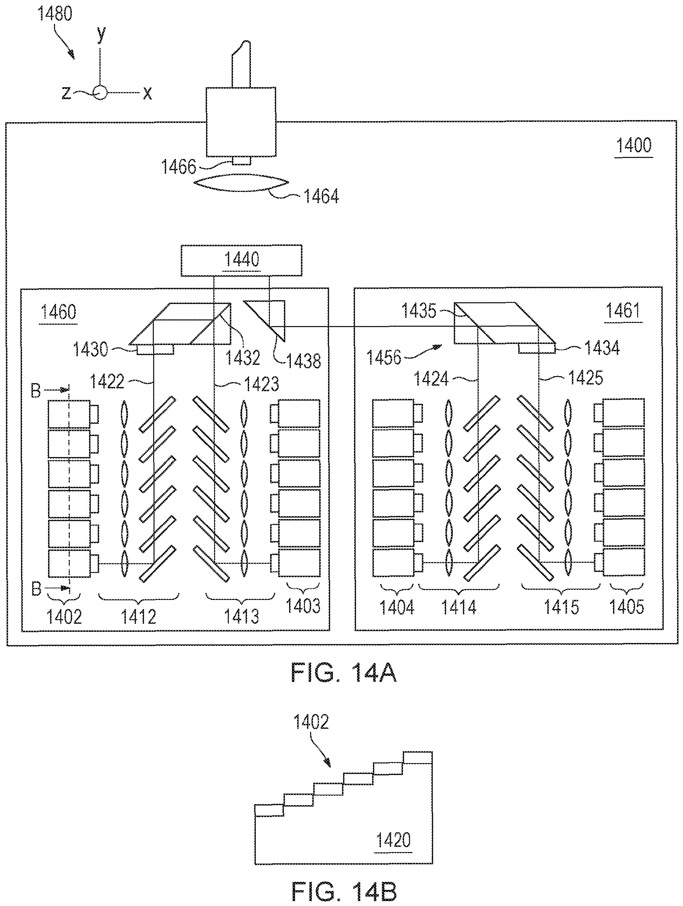

With reference to FIG. 14A, a laser diode assembly 1400 is described with reference to a right-handed xyz coordinate system 1480 in which a z-axis extends upwardly out of the plane of FIG. 14A. The laser diode assembly 1400 includes sets of coherent laser diodes 1402-1405 that are arranged to emit laser beams to corresponding phase masks, reflectors and fast and slow axis collimators 1412-1415. For example, the laser diodes of the set 1402 emit beams along an x-axis direction that are then redirected by respective reflectors of the set 1412 so as to propagate along a y-axis direction. The laser diodes of each set are displaced or offset from other laser diodes of the same set along a z-axis and the associated reflectors situated so that laser beams from the set are not blocked by the reflectors. As shown in FIG. 14B, the set of laser diodes 1402 is secured to a stepped mount 1420 to provide suitable z-axis offsets; similar mounts are provided for the remaining sets of laser diodes. For convenience, beam propagation axes 1422-1425 are shown for the bottom-most laser diodes of each set; beam propagation axes for the remaining laser diodes of each set are similar, but displaced along the z-axis.

The laser beams from the set of laser diodes 1402 are directed to a half-wave retarder 1430 and then combined with the laser beams from the set of laser diodes 1403 at a polarizing beam splitter 1432 so that a vertically stacked set of beams is incident to a beam spacing compressor 1440 that can be provided as a pair of cylindrical lenses. The laser beams from the set of laser diodes 1405 are directed by reflectors of the set 1415 to a half-wave retarder 1434 and then combined with the laser beams from the set of laser diodes 1404 as redirected by reflectors of the set 1414 at a polarizing beam splitter 1435 so that a vertically stacked set of beams is incident to the beam compressor 1440.

### Experimental and Simulated Results: Design Paradigms 1 and 2

LOC laser diodes of the present disclosure improve power and efficiency as a result of lower operating voltage from reduced electrical series resistance and higher slope efficiency from lower optical loss (i.e., a slope efficiency in power/current from the linear part of the laser power characteristic above threshold current). The laser diode performance of design paradigms 1 and 2 have been simulated using a self-consistent physics-based laser diode simulation tool. For comparison, simulation results of conventional LOC laser diodes are also provided.

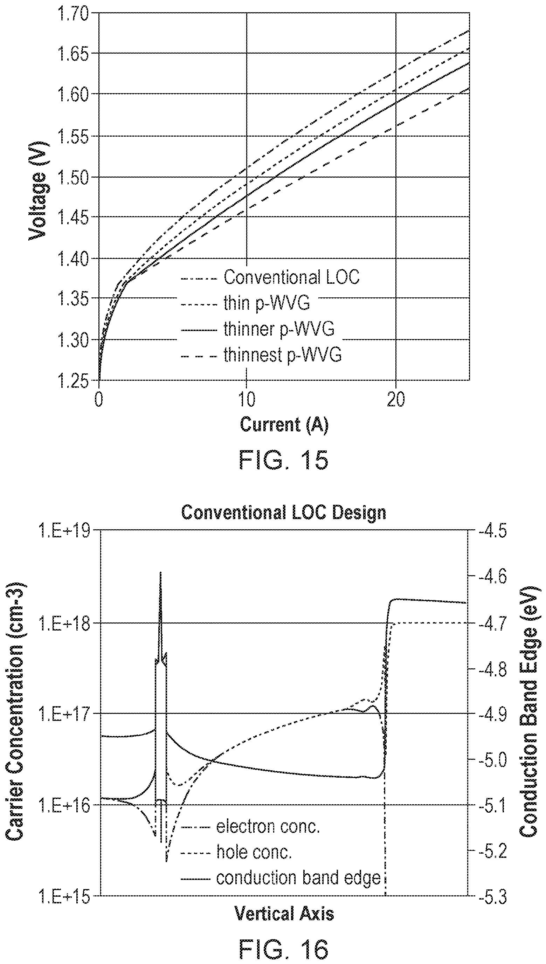

FIG. 15 plots the simulated laser diode voltage as a function of drive current for conventional LOC design and several thin p-waveguide designs following the double clad, thin p-waveguide paradigm of design paradigm 1. Because of the low mobility of holes, a majority of the electrical resistance in the conventional LOC is coming from the relatively thick p-waveguide. As shown in FIG. 15, thinning down the p-waveguide significantly lowers the electrical series resistance, hence lower voltage in the laser diodes.

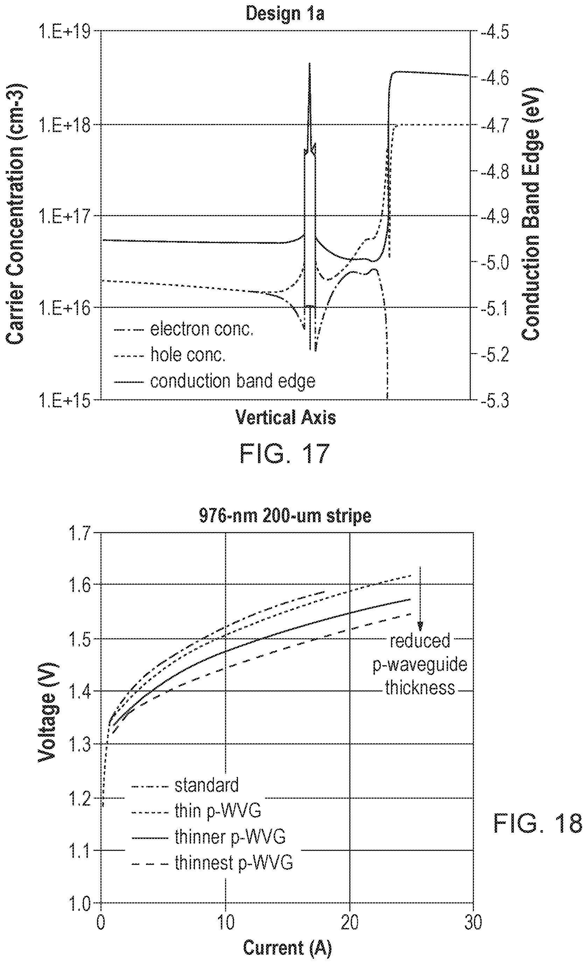

Bias-driven carrier leakage into the p-waveguide is a major power and efficiency detractor in conventional LOC, especially at high power high current operation. FIG. 16 shows the simulated electron, hole concentration, and conduction band edge for conventional LOC laser diode design under high power operation. Band bending (conduction band edge in the figure) occurs, leading to increased carrier leakage and accumulation (both electrons and holes, as shown in the figure) in the p-waveguide. This causes enhanced optical loss through free carrier absorption (especially inter-valence band absorption) in the p-waveguide, and shows as power saturation with increased current because of significantly accumulated carriers at high injection current. Reducing p-waveguide in the LOC structure, such as in design paradigm 1, is shown to mitigate band bending and carrier accumulation in the thinner p-waveguide, evidenced in the simulation results in FIG. 17. The power saturation effect is minimized and efficiency significantly improved at high injection current from the reduced optical loss.

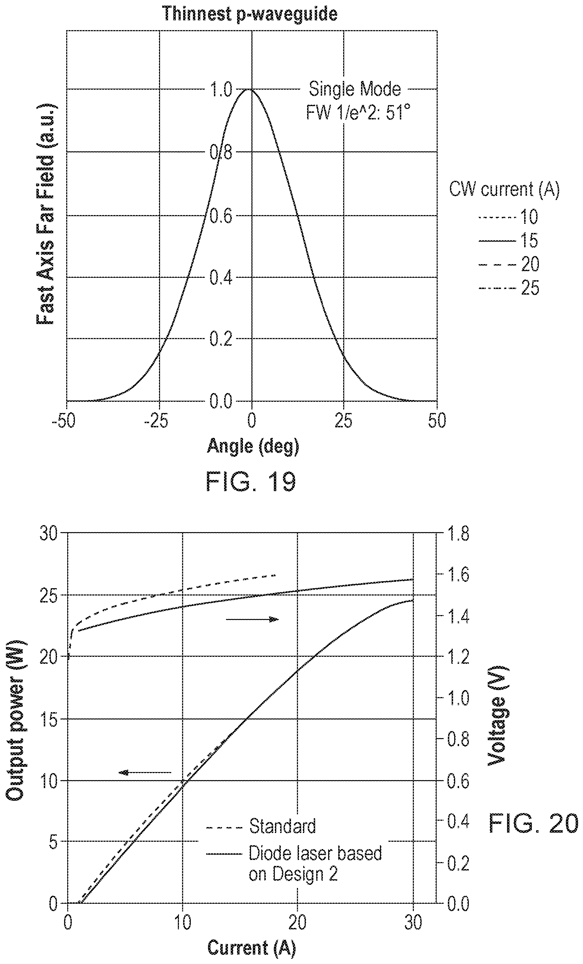

LOC laser diodes based on design paradigm 1 have been tested for confirming performance. FIG. 18 shows the measured voltage for the several thin p-waveguide designs of a 976-nm laser diode fabricated to have a stripe width of 200 µm (slow axis width). As much as 5.3% voltage reduction was observed in the thinnest p-waveguide design compared to the conventional LOC design. FIG. 19 plots the measured fast axis far field of thinnest p-waveguide design, showing not only comparable far field divergence angle as in conventional LOC design, but also single mode operation in the vertical direction for all measured currents up to 25 A.

FIG. 20 shows measured laser diode power and voltage as a function of drive current for conventional LOC design and for laser diodes design constructed according to design 2a. Results for a standard (i.e., conventional LOC, as in FIG. 15) device are also shown. In terms of the comparison between a standard device and one implemented according to design 2a, the graph shows voltage reduction realized by design 2a. This is a result of thinning down the p-waveguide thickness.

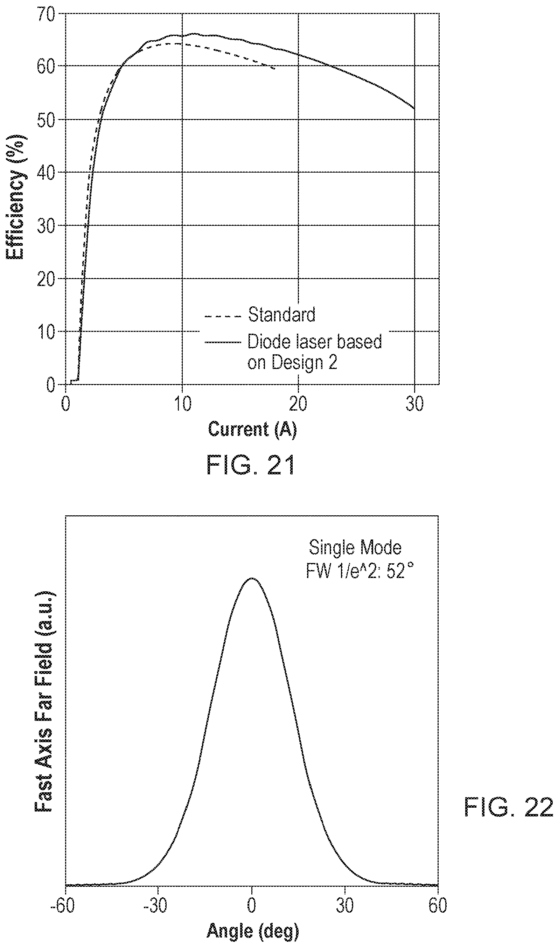

Because of the voltage reduction, efficiency (see FIG. 21) is higher in connection with design 2a. Specifically, FIG. 21 shows measured electrical-to-optical power conversion efficiency as a function of drive current for conventional LOC design and for laser diodes design constructed according to design 2a. The electrical-to-optical power conversion efficiency is defined as the output power divided by the product of voltage and current. Optical power is typically measured using a thermopile. The conventional LOC device exhibit lower efficiency at about 6.5 A and higher currents.

Finally, as shown in the fast axis far field of FIG. 22, although the p-waveguide is dramatically thinned, the device still maintains single mode operation. Thus, FIG. 22 plots the measured fast axis far field of a laser diode constructed according to design 2a using a thinnest p-waveguide design, and yet showing single mode operation in the vertical direction.

### Concluding Remarks

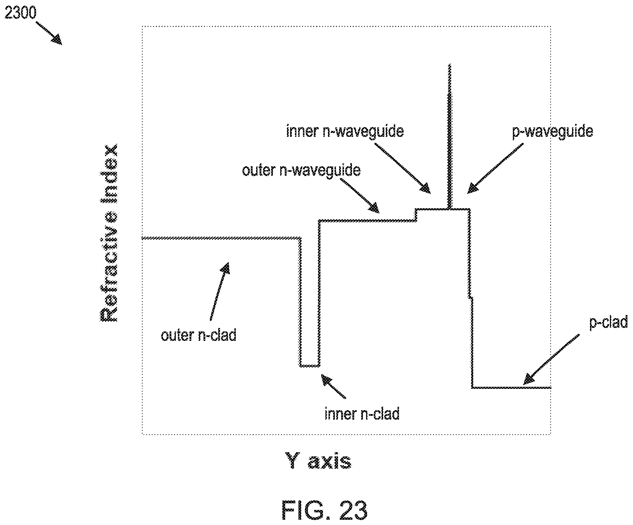

Skilled persons will appreciate that many changes may be made to the details of the above-described embodiments without departing from the the invention as described in the claims. For example, FIG. 23 shows another embodiment representing a combination of features shown in FIGS. 3 and 12. Specifically, a graph 2300 shows a double n-cladding (akin to that shown in FIG. 3) and double waveguide (akin to that shown in FIG. 12). A combination of these features provides further model discrimination attributable to the double n-cladding filtering and confinement factor differentiation attributable to the double waveguide as explained previously in connection with design paradigms 1a and 3, respectively. The scope of the present invention should, therefore, be determined only by the following claims.

## Claims

1. A large optical cavity, LOC, laser diode (200) configured to support lasing of a fundamental mode (356) and to suppress lasing of a first and higher order modes (370) along a fast axis of an optical beam emitted by the laser diode, the laser diode comprising:
an optical cavity defined by a p-side (214, 254, 250, 326, 338) of the laser diode, an n-side (230, 220, 216, 310, 320) of the laser diode, and an active region (210, 340, 344), including a quantum well (344), located between the p- and n-sides, the n-side including an n-waveguide layer (320) forming at least a portion of a multimode waveguide (350) having the quantum well (344) offset towards the p-side; and
adjacent cladding layers (316, 312, 716,712) on one or both of the p- and n-sides, the adjacent cladding layers including outer (316, 712) and inner (316, 716) cladding layers, the inner cladding layer situated between and adjacent to the multimode waveguide (350) and the outer cladding layer, the outer and inner cladding layers having, respectively, first and second indices of refraction, the first index of refraction of the outer cladding layer being greater than the second index of refraction of the inner cladding layer and greater than an effective index of refraction of the first order mode (370) so as to out-couple it from the multimode waveguide.

2. The LOC laser diode of claim 1, in which the n-side includes the adjacent cladding layers.

3. The LOC laser diode of claim 1, in which the p-side includes the adjacent cladding layers.

4. The LOC laser diode of claim 1, in which the p-side includes a p-cladding layer adjacent the active region such that the n-waveguide comprises substantially an entire portion of the multimode waveguide.

5. The LOC laser diode of any of claims 1-4, further comprising a graded-index refractive index profile adjacent to the active region.

6. The LOC laser diode of any of claims 1-4, further comprising a stepped-index refractive index profile adjacent to the active region.

7. The LOC laser diode of claim 4, further comprising an asymmetric graded-index refractive index profile adjacent to the active region.

8. The LOC laser diode of claim 4, further comprising an asymmetric stepped-index refractive index profile adjacent to the active region.

9. A large optical cavity, LOC, laser diode (200) configured to suppress lasing of a first and higher order modes (1270, 1370) along a fast axis of an optical beam emitted by the laser diode, the laser diode comprising:
an optical cavity defined by a p-side (214, 254, 250, 1266, 1366) of the laser diode, an n-side (230, 220, 216, 1260, 1262, 1360, 1354, 1362) of the laser diode, and an active region (210), including a quantum well, located between the p- and n-sides
a p-waveguide layer forming at least a portion of a multimode double waveguide 1250, 1350);
said quantum well being offset towards the p-side; and
a set of n-waveguide layers (1260, 1262, 1360, 1362) on the n-side that form at least a portion of the multimode double waveguide, the set of n-waveguide layers including outer (1260, 1360) and inner (1262, 1362) n-waveguide layers in which optical gain applied to the first and higher order modes (1270, 1370) is reduced relative to optical gain applied to a fundamental mode

10. The LOC laser diode of claim 9, in which the inner n-waveguide layer is situated between and adjacent to the active region and the outer n-waveguide layer, the outer and inner n-waveguide layers having, respectively, first and second indices of refraction, the first index of refraction of the outer n-waveguide layer being less than the second index of refraction of the inner n-waveguide layer.

11. The LOC laser diode of claim 9 or 10, in which the multimode double waveguide has an asymmetric refractive index.

12. The LOC laser diode of claim 9 or 10, further comprising adjacent n-cladding layers, the adjacent n-cladding layers including outer and inner cladding layers, the inner cladding layer situated between and adjacent to the outer n-waveguide layer and the outer cladding layer, the outer and inner cladding layers having, respectively, first and second indices of refraction, the first index of refraction of the outer cladding layer being greater than the second index of refraction of the inner cladding layer and greater than an effective index of refraction of the first order mode so as to out-couple it from at least the inner n-waveguide layer.

13. The LOC laser diode of claim 9, in which the set of n-waveguide layers form at least a portion of a symmetric waveguide having matching indices of refraction and being separated by a cladding layer having an index of refraction that is less than that of the set of n-waveguide layers.

14. The LOC laser diode of claim 13, in which the cladding layer is offset to the n-side such that a first portion of the multimode double waveguide is wider than a second portion of the multimode double waveguide, the first portion including the inner n-waveguide and p-waveguide layers, and the second portion including the outer n-waveguide layer.

15. A diode laser assembly including the LOC laser diode of claim 1 or 9.

## Patentansprüche

1. Eine Laserdiode (200) mit großem optischem Resonator, LOC, die konfiguriert ist, um das Lasern einer Grundmode (356) zu unterstützen und das Lasern einer Mode erster Ordnung und Moden höherer Ordnung (370) entlang einer schnellen Achse eines optischen Strahls, der durch die Laserdiode emittiert wird, zu unterdrücken, wobei die Laserdiode Folgendes beinhaltet:
einen optischen Resonator, der durch eine p-Seite (214, 254, 250, 326, 338) der Laserdiode, eine n-Seite (230, 220, 216, 310, 320) der Laserdiode und einen aktiven Bereich (210, 340, 344), der einen Quantentopf (344), der sich zwischen der p- und der n-Seite befindet, umfasst, definiert ist, wobei die n-Seite eine n-Wellenleiterschicht (320) umfasst, die mindestens einen Teil eines Multimode-Wellenleiters (350) bildet, bei dem der Quantentopf (344) zu der p-Seite versetzt ist; und
angrenzende Verkleidungsschichten (316, 312, 716, 712) auf einer oder auf beiden der p- und der n-Seite, wobei die angrenzenden Verkleidungsschichten eine äußere (316, 712) und eine innere (316, 716) Verkleidungsschicht umfassen, wobei die innere Verkleidungsschicht zwischen dem Multimode-Wellenleiter (350) und der äußeren Verkleidungsschicht und angrenzend an diese gelegen ist, wobei die äußere und innere Verkleidungsschicht jeweils einen ersten und einen zweiten Brechungsindex aufweisen, wobei der erste Brechungsindex der äußeren Verkleidungsschicht größer als der zweite Brechungsindex der inneren Verkleidungsschicht und größer als ein effektiver Brechungsindex der Mode erster Ordnung (370) ist, um sie aus dem Multimode-Wellenleiter auszukoppeln.

2. LOC-Laserdiode gemäß Anspruch 1, wobei die n-Seite die angrenzenden Verkleidungsschichten umfasst.

3. LOC-Laserdiode gemäß Anspruch 1, wobei die p-Seite die angrenzenden Verkleidungsschichten umfasst.

4. LOC-Laserdiode gemäß Anspruch 1, wobei die p-Seite eine p-Verkleidungsschicht angrenzend an den aktiven Bereich umfasst, sodass der n-Wellenleiter im Wesentlichen einen gesamten Teil des Multimode-Wellenleiters beinhaltet.

5. LOC-Laserdiode gemäß einem der Ansprüche 1-4, die ferner ein Brechungsindexprofil mit Gradientenindex angrenzend an den aktiven Bereich beinhaltet.

6. LOC-Laserdiode gemäß einem der Ansprüche 1-4, die ferner ein Brechungsindexprofil mit Stufenindex angrenzend an den aktiven Bereich beinhaltet.

7. LOC-Laserdiode gemäß Anspruch 4, die ferner ein asymmetrisches Brechungsindexprofil mit Gradientenindex angrenzend an den aktiven Bereich beinhaltet.

8. LOC-Laserdiode gemäß Anspruch 4, die ferner ein asymmetrisches Brechungsindexprofil mit Stufenindex angrenzend an den aktiven Bereich beinhaltet.

9. Eine Laserdiode (200) mit großem optischem Resonator, LOC, die konfiguriert ist, um das Lasern einer Mode erster Ordnung und Moden höherer Ordnung (1270, 1370) entlang einer schnellen Achse eines optischen Strahls, der durch die Laserdiode emittiert wird, zu unterdrücken, wobei die Laserdiode Folgendes beinhaltet:
einen optischen Resonator, der durch eine p-Seite (214, 254, 250, 1266, 1366) der Laserdiode, eine n-Seite (230, 220, 216, 1260, 1262, 1360, 1354, 1362) der Laserdiode und einen aktiven Bereich (210), der einen Quantentopf, der sich zwischen der p- und der n-Seite befindet, umfasst, definiert ist;
eine p-Wellenleiterschicht, die mindestens einen Teil eines Multimode-Doppelwellenleiters (1250, 1350) bildet;
wobei der Quantentopf zu der p-Seite versetzt ist; und
einen Satz von n-Wellenleiterschichten (1260, 1262, 1360, 1362) auf der n-Seite, die mindestens einen Teil des Multimode-Doppelwellenleiters bilden, wobei der Satz von n-Wellenleiterschichten eine äußere (1260, 1360) und eine innere (1262, 1362) n-Wellenleiterschicht umfasst, in denen eine optische Verstärkung, die auf die Mode erster Ordnung und die Moden höherer Ordnung (1270, 1370) angewendet wird, relativ zu einer optischen Verstärkung, die auf eine Grundmode angewendet wird, reduziert wird.

10. LOC-Laserdiode gemäß Anspruch 9, wobei die innere n-Wellenleiterschicht zwischen dem aktiven Bereich und der äußeren n-Wellenleiterschicht und angrenzend an diese gelegen ist, wobei die äußere und innere n-Wellenleiterschicht jeweils einen ersten und einen zweiten Brechungsindex aufweisen, wobei der erste Brechungsindex der äußeren n-Wellenleiterschicht kleiner als der zweite Brechungsindex der inneren n-Wellenleiterschicht ist.

11. LOC-Laserdiode gemäß Anspruch 9 oder 10, wobei der Multimode-Doppelwellenleiter einen asymmetrischen Brechungsindex aufweist.

12. LOC-Laserdiode gemäß Anspruch 9 oder 10, die ferner angrenzende n-Verkleidungsschichten beinhaltet, wobei die angrenzenden n-Verkleidungsschichten eine äußere und eine innere Verkleidungsschicht umfassen, wobei die innere Verkleidungsschicht zwischen der äußeren n--Wellenleiterschicht und der äußeren Verkleidungsschicht und an diese angrenzend gelegen ist, wobei die äußere und die innere Verkleidungsschicht jeweils einen ersten und einen zweiten Brechungsindex aufweisen, wobei der erste Brechungsindex der äußeren Verkleidungsschicht größer als der zweite Brechungsindex der inneren Verkleidungsschicht und größer als ein effektiver Brechungsindex der Mode erster Ordnung ist, um sie aus mindestens der inneren n-Wellenleiterschicht auszukoppeln.

13. LOC-Laserdiode gemäß Anspruch 9, wobei der Satz von n-Wellenleiterschichten mindestens einen Teil eines symmetrischen Wellenleiters mit passenden Brechungsindizes bildet und durch eine Verkleidungsschicht getrennt ist, die einen Brechungsindex aufweist, der kleiner als der des Satzes von n-Wellenleiterschichten ist.

14. LOC-Laserdiode gemäß Anspruch 13, wobei die Verkleidungsschicht so zu der n-Seite versetzt ist, dass ein erster Teil des Multimode-Doppelwellenleiters breiter als ein zweiter Teil des Multimode-Doppelwellenleiters ist, wobei der erste Teil die innere n-Wellenleiter- und p-Wellenleiterschicht umfasst und der zweite Teil die äußere n-Wellenleiterschicht umfasst.

15. Eine Diodenlaseranordnung, die die LOC-Laserdiode gemäß Anspruch 1 oder 9 umfasst.

## Revendications

1. Une diode laser (200) à cavité optique large (LOC, *Large Optical Cavity*) configurée pour supporter le lasage d'un mode fondamental (356) et pour supprimer le lasage de modes d'un premier ordre et d'ordre supérieur (370) le long d'un axe rapide d'un faisceau optique émis par la diode laser, la diode laser comprenant :
une cavité optique définie par un côté p (214, 254, 250, 326, 338) de la diode laser, un côté n (230, 220, 216, 310, 320) de la diode laser, et une région active (210, 340, 344), incluant un puits quantique (344), se trouvant entre les côtés p et n, le côté n incluant une couche guide d'ondes n (320) formant au moins une portion d'un guide d'ondes multimode (350) ayant le puits quantique (344) décalé vers le côté p ; et
des couches de confinement (316, 312, 716, 712) adjacentes sur l'un des côtés p et n ou les deux, les couches de confinement adjacentes incluant des couches de confinement externe (316, 712) et interne (316, 716), la couche de confinement interne étant située entre le guide d'ondes multimode (350) et la couche de confinement externe et adjacente à ceux-ci, les couches de confinement externe et interne ayant, respectivement, des premier et deuxième indices de réfraction, le premier indice de réfraction de la couche de confinement externe étant plus grand que le deuxième indice de réfraction de la couche de confinement interne et plus grand qu'un indice de réfraction effectif du mode de premier ordre (370) de façon à le découpler du guide d'ondes multimode.

2. La diode laser LOC de la revendication 1, dans laquelle le côté n inclut les couches de confinement adjacentes.

3. La diode laser LOC de la revendication 1, dans laquelle le côté p inclut les couches de confinement adjacentes.

4. La diode laser LOC de la revendication 1, dans laquelle le côté p inclut une couche de confinement p adjacente à la région active de telle sorte que le guide d'ondes n comprend substantiellement une portion entière du guide d'ondes multimode.

5. La diode laser LOC de n'importe lesquelles des revendications 1 à 4, comprenant en outre un profil d'indice de réfraction à gradient d'indice adjacent à la région active.

6. La diode laser LOC de n'importe lesquelles des revendications 1 à 4, comprenant en outre un profil d'indice de réfraction à saut d'indice adjacent à la région active.

7. La diode laser LOC de la revendication 4, comprenant en outre un profil d'indice de réfraction à gradient d'indice asymétrique adjacent à la région active.

8. La diode laser LOC de la revendication 4, comprenant en outre un profil d'indice de réfraction à saut d'indice asymétrique adjacent à la région active.

9. Une diode laser (200) à cavité optique large, LOC, configurée pour supprimer le lasage de modes d'un premier ordre et d'ordre supérieur (1270, 1370) le long d'un axe rapide d'un faisceau optique émis par la diode laser, la diode laser comprenant :
une cavité optique définie par un côté p (214, 254, 250, 1266, 1366) de la diode laser, un côté n (230, 220, 216, 1260, 1262, 1360, 1354, 1362) de la diode laser, et une région active (210), incluant un puits quantique, se trouvant entre les côtés p et n ;
une couche guide d'ondes p formant au moins une portion d'un guide d'ondes double multimode (1250, 1350) ;
ledit puits quantique étant décalé vers le côté p ; et
un ensemble de couches guide d'ondes n (1260, 1262, 1360, 1362) sur le côté n qui forment au moins une portion du guide d'ondes double multimode, l'ensemble de couches guide d'ondes n incluant des couches guide d'ondes n externe (1260, 1360) et interne (1262, 1362) dans lesquelles un gain optique appliqué aux modes de premier ordre et d'ordre supérieur (1270, 1370) est réduit relativement à un gain optique appliqué à un mode fondamental.

10. La diode laser LOC de la revendication 9, dans laquelle la couche guide d'ondes n interne est située entre la région active et la couche guide d'ondes n externe et adjacente à celles-ci, les couches guide d'ondes n externe et interne ayant, respectivement, des premier et deuxième indices de réfraction, le premier indice de réfraction de la couche guide d'ondes n externe étant plus petit que le deuxième indice de réfraction de la couche guide d'ondes n interne.

11. La diode laser LOC de la revendication 9 ou de la revendication 10, dans laquelle le guide d'ondes double multimode a un indice de réfraction asymétrique.

12. La diode laser LOC de la revendication 9 ou de la revendication 10, comprenant en outre des couches de confinement n adjacentes, les couches de confinement n adjacentes incluant des couches de confinement externe et interne, la couche de confinement interne étant située entre la couche guide d'ondes n externe et la couche de confinement externe et adjacente à celles-ci, les couches de confinement externe et interne ayant, respectivement, des premier et deuxième indices de réfraction, le premier indice de réfraction de la couche de confinement externe étant plus grand que le deuxième indice de réfraction de la couche de confinement interne et plus grand qu'un indice de réfraction effectif du mode de premier ordre de façon à le découpler au moins de la couche guide d'ondes n interne.

13. La diode laser LOC de la revendication 9, dans laquelle l'ensemble de couches guide d'ondes n forment au moins une portion d'un guide d'ondes symétrique ayant des indices de réfraction concordants et étant séparé par une couche de confinement ayant un indice de réfraction qui est plus petit que celui de l'ensemble de couches guide d'ondes n.

14. La diode laser LOC de la revendication 13, dans laquelle la couche de confinement est décalée sur le côté n de telle sorte qu'une première portion du guide d'ondes double multimode est plus large qu'une deuxième portion du guide d'ondes double multimode, la première portion incluant les couches guide d'ondes n et guide d'ondes p internes, et la deuxième portion incluant la couche guide d'ondes n externe.

15. Un ensemble laser à diode incluant la diode laser LOC de la revendication 1 ou de la revendication 9.
